# EUROPÄISCHE PATENTSCHRIFT

(11) **EP 0 735 603 B1**
(45) Veröffentlichungstag und Bekanntmachung des Hinweises auf die Patenterteilung: **09.07.2003**
(21) Anmeldenummer: 96200709.2
(22) Anmeldetag: 14.03.1996
(51) Int. Cl.: H01P 1/161, H03F 3/60, H03F 3/72

(54) **Schaltungsanordnung zum Verarbeiten eines ersten oder eines zweiten Hochfrequenzsignals**
Circuit for processing a first or a second high frequency signal
Dispositif de traitement d'un premier ou d'un second signal haute fréquence

(30) Priorität: 25.03.1995 DE 19511103
(43) Veröffentlichungstag der Anmeldung: 02.10.1996
(73) Patentinhaber: Skyware Radio Systems GmbH, 47809 Krefeld (DE)
(72) Erfinder: Schiltmans, Ronald, 22335 Hamburg (DE)
(74) Vertreter: Kreutzer, Ulrich, Dipl.-Phys.

(56) Entgegenhaltungen:
- EP-A- 0 350 323
- FR-A- 2 608 862
- GB-A- 2 235 340
- US-A- 3 654 566
- IEEE 1990 MICROWAVE AND MILLMETER-WAVE MONOLITHIC CIRCUITS SYMPOSIUM, 7. - 8.Mai 1990, DALLAS (US), Seiten 1-6, XP000217163 Y. KONISHI: "GaAs devices and the MIC applications in satellite broadcasting"

## Beschreibung

Die Erfindung bezieht sich auf eine Schaltungsanordnung zum Verarbeiten wahlweise eines ersten oder eines zweiten Hochfrequenzsignals gemäß dem Oberbegriff des Patentanspruchs 1.

Aus der US-PS 4,959,873 ist ein Übertragungsleitungs-Schalter bekannt, der es erlaubt, eine einzelne Ausgangsleitung auf eine von zwei oder mehr Eingangsleitungen zu schalten, an die die Ausgangsleitung über einen Knotenpunkt angeschlossen ist. Dabei ist jeder Eingangsleitung eine Verstärkerstufe zugeordnet, die durch Zuführen von Versorgungsspannungen in einen eingeschalteten Zustand mit hoher Verstärkung oder in einen ausgeschalteten Zustand überführt werden kann, in dem sie eine Trennung bildet. Dabei soll durch geeignete Gleichspannungsspeisung im abgeschalteten Zustand erreicht werden, daß die Verstärkerstufe an ihrem Ausgang für die zugehörige Eingangsleitung eine niedrige Impedanz bildet. Die Länge dieser zugehörigen Eingangsleitung ist derart gewählt, daß am Knotenpunkt mit den übrigen Leitungen eine hohe Impedanz erscheint. Ferner soll durch korrekte Dimensionierung erreicht werden, daß Rückflußdämpfung und Einfügungsdämpfung des eingeschalteten Signalweges niedrig gehalten werden und gleichzeitig im abgeschalteten Signalweg eine hohe Einfügungsdämpfung erzielt wird.

Aus der DE-OS 43 05 908 ist eine Wellenleiteranordnung zur Kopplung von in einem Wellenleiterinnenraum geführter Energie mit zwei Signalleitungen bekannt, welche mit je einer in den Wellenleiterinnenraum ragenden Sonde gekoppelt sind. Ein in dem Wellenleiterinnenraum bezüglich dessen Querschnitt zentral angeordnetes leitfähiges Resonanzelement ist auf die Wellenlänge der in dem Wellenleiterinnenraum geführten Energie so abgestimmt, daß es die Energie möglichst gut aufnehmen kann und daß die aufgenommene Energie auf die Sonden die orthogonal zur Längsachse des Wellenleiterinnenraums und orthogonal zueinander angeordnet sind, ausgekoppelt wird. Eine ähnliche Wellenleiteranordnung, bei der anstelle des Resonanzelementes ein elektrisch leitfähiges Trennelement in dem Wellenleiterinnenraum vorgesehen ist, ist aus der DE-OS 43 05 906 bekannt. Mit diesen Wellenleiteranordnungen können kreuzpolarisierte Wellen empfangen und mit guter Kreuzpolarisationsentkopplung voneinander getrennt den Eingangsleitungen der aus der US-PS 4,959,873 bekannten Anordnung zugeführt werden.

Aus der GB 2 235 340 A ist ein Signalempfänger für Satellitenrundfunk bekannt, der zwei Sonden aufweist, die in einem Wellenleiter zum Empfangen unterschiedlich polarisierter Wellen angeordnet sind; beispielsweise für sowohl horizontal als auch vertikal polarisierte Wellen. Die Sonden sind im Wellenleiter senkrecht zueinander angeordnet. Jede der Sonden ist mit einem Eingangsanschluß je eines Verstärkers verbunden. Mit dieser Anordnung ist es möglich, gleichzeitig sowohl vertikal als auch horizontal polarisierte Wellen zu empfangen, ohne eine drehbare Sonde zu benötigen. In einer Abwandlung des Signalempfängers können sowohl im als auch entgegen dem Uhrzeigersinn zirkular polarisierte Wellen empfangen werden. Die Verstärker können jeder einen Ga-As-Feldeffekttransistor enthalten, der wahlweise zum Empfangen der benötigten, vertikal oder horizontal polarisierten Wellen eingeschaltet werden kann.

Der in der GB 2 235 340 A beschriebene Signalempfänger geht insoweit über eine Kombination der aus den Druckschriften DE-OS 43 05 906 und US-PS 4,959,873 bekannten Anordnungen nicht hinaus.

In der Praxis hat sich jedoch gezeigt, daß die mit einer solchen Anordnung erreichten Wellenwiderstandsanpassungen für eine bestimmte Dimensionierung nur in einem Frequenzband erreichbar sind, welches für die Übertragung bestimmter Hochfrequenzsignale nicht ausreicht. Bei Übertragung von Hochfrequenzsignalen mit höherer, relativer Bandbreite tritt dann am Rande des übertragenen Frequenzbandes bereits eine deutliche Fehlanpassung entweder im eingeschalteten oder im abgeschalteten Zustand der Verstärkerstufe auf.

Dadurch entstehen Reflexionen, durch die in nicht mehr vertretbarem Maße Störungen in die empfangenen Hochfrequenzsignale eingestreut werden. Insbesondere wird durch diese Reflexionen, d.h. durch sie auslösende Fehlanpassungen, eine Kreuzpolarisation mit der Folge eines Übersprechens zwischen den kreuzpolarisierten Wellen erzeugt, wodurch die Kreuzpolarisationsentkopplung verschlechtert wird. Außerdem tritt durch die Fehlanpassung ein Übertragungsverlust, d.h. eine Dämpfung der Wellen, auf. Auch eine sorgfältige Abstimmung und Anpassung der Wellenwiderstände und der Leitungslängen führt nicht zu einer hinreichenden Verminderung dieser Störungen.

Die Erfindung hat die Aufgabe, eine Schaltungsanordnung der eingangs genannten Art zu schaffen, in der auf einfache Weise eine Verarbeitung breitbandigerer Signale als bisher mit niedrigen Störungen möglich ist.

Diese Aufgabe wird bei einer Schaltungsanordnung nach dem Oberbegriff des Patentanspruchs 1 erfindungsgemäß gelöst durch die Merkmale des kennzeichnenden Teils des Patentanspruchs 1.

Der Erfindung liegt die Erkenntnis zugrunde, daß Schwierigkeiten bei der Wellenwiderstandsanpassung insbesondere dadurch auftreten, daß die Eingangsimpedanz der schaltbaren Hochfrequenz-Verstärkeranordnungen zwischen dem durchgeschalteten und dem gesperrten Zustand verändert wird. Es ist dann nicht mehr möglich, die Einkoppelvorrichtungen und die schaltbaren Hochfrequenz-Verstärkeranordnungen für beide Betriebszustände dieser Hochfrequenz-Verstärkeranordnungen über eine große Bandbreite mit der gewünschten Genauigkeit aneinander anzupassen. Die erfindungsgemäß eingefügten Hochfrequenz-Vorverstärker, die sich dauernd im durchgeschalteten Zustand befinden, bilden nun für die Einkoppelvorrichtungen in jedem Betriebszustand einen Abschluß fester Impedanz, der sich breitbandig an die Einkoppelvorrichtungen anpassen läßt. Die Ausgangswiderstände dieser Hochfrequenz-Vorverstärker lassen sich andererseits leichter an die wechselnden Eingangswiderstände der zugeordneten, schaltbaren Hochfrequenz-Verstärkeranordnungen anpassen. Durch die zweistufige Anordnung in jedem Signalverarbeitungszweig läßt sich außerdem eine höhere Signalverstärkung erzielen. Durch gute Anpassung entstehen dabei allenfalls sehr geringe Reflexionen in einem breiten Frequenzband, so daß insgesamt eine sehr störungsarme Signalverarbeitung für sehr breitbandige Hochfrequenzsignale ermöglicht wird. Ein bevorzugter Einsatzbereich derartiger Schaltungsanordnungen ist der Empfang von Satellitensignalen, für den durch die Erfindung eine sehr einfache, leistungsfähige und preiswerte Anordnung geschaffen wird.

Eine vorteilhafte Weiterbildung der Erfindung ist dadurch gekennzeichnet, daß die Wellenleiteranordnung mit einem Hohlraum ausgeführt ist und daß die Einkoppelvorrichtungen je eine in diesen Hohlraum ragende Sonde umfassen, wobei die Sonden auf die Wellenlänge der im Hohlraum der Wellenleiteranordnung geführten Hochfrequenzsignale derart abgestimmt sind, daß sie die Energie dieser Hochfrequenzsignale aus der Wellenleiteranordnung möglichst gut aufnehmen.

Mit diesen, insbesondere nach den Offenlegungsschriften 43 05 906 und 43 05 908 gestalteten Einkoppelvorrichtungen lassen sich sehr kompakte, leistungsfähige Satellitenempfangsanordnungen ausbilden. Aufgrund der großen Bandbreite und der durch die Art der Einkoppelvorrichtungen ermöglichten hohen Kanaldichte kann damit eine einzige Schaltungsanordnung der erfindungsgemäßen Art in einer einzigen Dimensionierung für eine sehr hohe Anzahl von Hochfrequenzsignalen verwendet werden. Beispielsweise kann dadurch die Zahl von einem Satelliten empfangener Fernsehprogramme, die von einer einzigen Empfangsanordnung verarbeitbar sind, erheblich gesteigert werden. Ein erhöhtes Programmangebot kann daher mit sehr geringem apparativem Aufwand ausgenutzt werden.

Eine andere, vorteilhafte Weiterbildung zeichnet sich dadurch aus, daß die ersten Koppelglieder je eine Signalleitung umfassen, über die die Hochfrequenzsignale von der zugehörigen Einkoppelvorrichtung zum zugehörigen Hochfrequenz-Vorverstärker geleitet wird, und daß Länge und Wellenwiderstand dieser Signalleitung auf eine wenigstens nahezu reflexionsfreie Signalübertragung abgestimmt sind. Dadurch wird eine sehr einfache Leiteranordnung mit sehr störungsarmer Übertragungseigenschaft erhalten.

Vorzugsweise sind die Hochfrequenz-Vorverstärker und die schaltbaren Hochfrequenz-Verstärkeranordnungen mit Transistoren mit hoher Ladungsträgerbeweglichkeit ausgebildet. Durch Verwendung derartiger "HEMT"-Transistoren, die ein sehr geringes Eigenrauschen aufweisen, wird trotz Hinzufügung der Hochfrequenz-Vorverstärker zu den schaltbaren Hochfrequenz-Verstärkeranordnungen eine sehr rauscharme Übertragung der Hochfrequenzsignale erreicht.

Bevorzugt weisen die zweiten Koppelglieder je ein Gleichstromtrennelement auf, durch welches der Hochfrequenz-Vorverstärker von der zugehörigen schaltbaren Hochfrequenz-Verstärkeranordnung gleichstrommäßig getrennt wird. Dadurch wird die getrennte Zufuhr von Versorgungsspannungen vereinfacht.

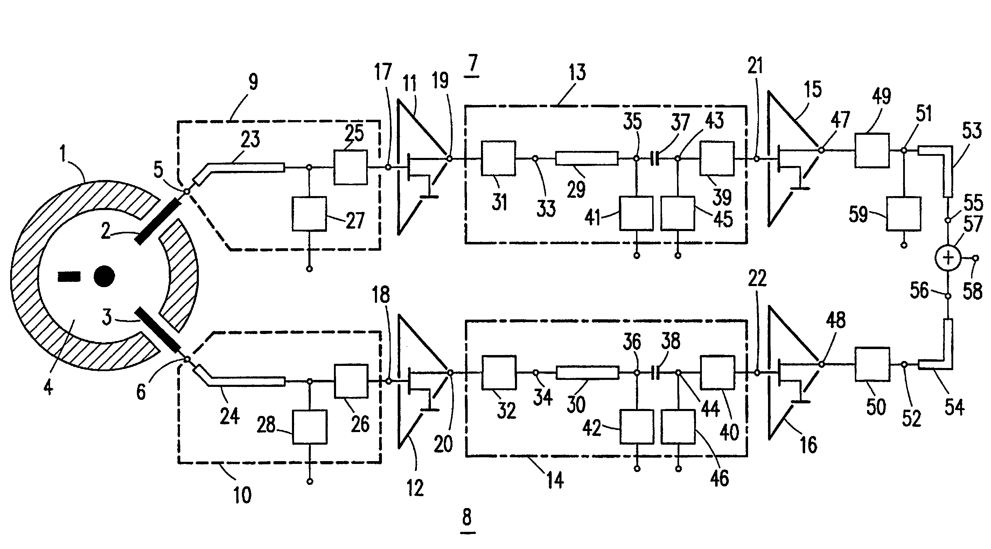

In der Figur ist ein Ausführungsbeispiel einer erfindungsgemäßen Schaltungsanordnung dargestellt. Dieses Ausführungsbeispiel umfaßt eine Wellenleiteranordnung 1, die vorzugsweise gemäß der DE-OS 43 05 908 ausgebildet ist. Auf die Offenbarung dieses Dokuments wird für die Beschreibung der vorliegenden Erfindung ausdrücklich Bezug genommen, so daß eine nähere Beschreibung der Wellenleiteranordnung 1 an dieser Stelle unterbleibt. Wahlweise kann die Wellenleiteranordnung 1 auch wie in der DE-OS 43 05 906 beschrieben ausgestaltet sein. Auch auf die Offenbarung dieser letztgenannten Offenlegungsschrift wird hiermit ausdrücklich Bezug genommen, ohne daß eine Wiederholung der dortigen Beschreibung vorgenommen werden soll.

Die Wellenleiteranordnung 1 umfaßt eine erste Einkoppelvorrichtung 2 und eine zweite Einkoppelvorrichtung 3. Beide Einkoppelvorrichtungen 2, 3 umfassen im wesentlichen je eine in einen Hohlraum 4 der Wellenleiteranordnung 1 ragende Sonde. Diese Sonden sind auf die Wellenlänge der im Hohlraum 4 der Wellenleiteranordnung 1 geführten Hochfrequenzsignale derart abgestimmt, daß sie die Energie dieser Hochfrequenzsignale aus der Wellenleiteranordnung 1 möglichst gut aufnehmen. Die Hochfrequenzsignale stehen dann an Anschlüssen 5, 6 der Einkoppelvorrichtungen 2 bzw. 3 zur weiteren Verarbeitung an.

Das Ausführungsbeispiel umfaßt weiterhin einen ersten Signalverarbeitungszweig 7 und einen zweiten Signalverarbeitungszweig 8. Jeder der Signalverarbeitungszweige 7 bzw. 8 umfaßt ein erstes Koppelglied 9 bzw. 10, deren Eingänge von den Anschlüssen 5 bzw. 6 der Einkoppelvorrichtungen 2 bzw. 3 gebildet werden, sowie je einen Hochfrequenz-Vorverstärker 11, 12, je ein zweites Koppelglied 13 bzw. 14 und je eine schaltbare Hochfrequenz-Verstärkeranordnung 15 bzw. 16. Dabei ist in jedem der Signalverarbeitungszweige 7 bzw. 8 das erste Koppelglied 9 bzw. 10 an seinem Ausgang 17 bzw. 18 mit einem Eingang des Hochfrequenz-Vorverstärkers 11 bzw. 12 verbunden. Ausgänge 19 bzw. 20 der Hochfrequenz-Vorverstärker 11 bzw. 12 sind mit Eingängen der zweiten Koppelglieder 13 bzw. 14 verbunden, deren Ausgänge 21 bzw. 22 mit Eingängen der zugehörigen, schaltbaren Hochfrequenz-Verstärkeranordnungen 15 bzw. 16 verbunden sind.

Jedes der ersten Koppelglieder 9 bzw. 10 umfaßt eine Signalleitung 23 bzw. 24, über die die Hochfrequenzsignale von der zugehörigen Einkoppelvorrichtung 2 bzw. 3 zum zugehörigen Hochfrequenz-Vorverstärker 11 bzw. 12 geleitet wird. Dabei kann die Länge und der Wellenwiderstand dieser Signalleitungen 23 bzw. 24 auf eine wenigstens nahezu reflexionsfreie Signalübertragung von den Einkoppelvorrichtungen 2 bzw. 3 auf die Hochfrequenz-Vorverstärker 11 bzw. 12 abgestimmt sein. Bevorzugt kann der Wellenwiderstand der Signalleitung 23 bzw. 24 an den Wellenwiderstand der zugehörigen Einkoppelvorrichtung 2 bzw. 3 angepaßt sein, so daß ein reflexionsfreier Übergang von der Einkoppelvorrichtung 2 bzw. 3 auf die Signalleitung 23 bzw. 24 erfolgt. Wenn dann, wie in der Figur dargestellt, zwischen die Signalleitung 23 bzw. 24 und den Ausgang 17 bzw. 18 des ersten Koppelgliedes 9 bzw. 10 eine erste Anpaßschaltung 25 bzw. 26 eingefügt ist, kann die Wellenwiderstandsanpassung zwischen der Signalleitung 23 bzw. 24 und dem Hochfrequenz-Vorverstärker 11 bzw. 12 sogar unabhängig von der Leitungslänge der Signalleitung 23 bzw. 24 erfolgen. Dies schafft einen zusätzlichen Freiheitsgrad für die Dimensionierung der erfindungsgemäßen Schaltungsanordnung.

Die ersten Koppelglieder 9 bzw. 10 umfassen weiterhin je eine erste Gleichstromkoppelanordnung 27 bzw. 28. Diese Gleichstromkoppelanordnungen 27 bzw. 28 sind zusammen mit den ersten Anpaßschaltungen 25 bzw. 26 derart dimensioniert, daß an den Hochfrequenz-Vorverstärkern 11 bzw. 12 zugewandten Enden der Signalleitungen 23 bzw. 24 ebenfalls Wellenwiderstandsanpassung vorliegt, wobei für den Übergang der Hochfrequenzsignale von den ersten Koppelgliedern 9 bzw. 10 auf die Hochfrequenz-Vorverstärker 11 bzw. 12 eine Wellenwiderstandstransformation stattfindet und die Gleichstromkoppelanordnungen 27 bzw. 28 eine möglichst hohe Dämpfung für die Hochfrequenzsignale aufweisen. Im übrigen dienen die Gleichstromkoppelanordnungen 27, 28 der Gleichstromzufuhr an die Eingänge der Hochfrequenz-Vorverstärker 11 bzw. 12.

Die Hochfrequenz-Vorverstärker 11 bzw. 12 werden im vorliegenden Ausführungsbeispiel durch Feldeffekttransistoren mit hoher Ladungsträgerbeweglichkeit gebildet, sogenannte "HEMT"-Transistoren. Diese weisen ein sehr niedriges Eigenrauschen auf, so daß eine sehr rauscharme Vorverstärkung der Hochfrequenzsignale möglich ist, die an dieser Stelle der Signalverarbeitungszweige 7 bzw. 8 noch sehr geringe Amplituden aufweisen. An den Ausgängen 19 bzw. 20 geben die Hochfrequenz-Vorverstärker 11 bzw. 12 vorverstärkte Hochfrequenzsignale ab.

Die zweiten Koppelglieder 13 bzw. 14 umfassen ebenfalls je eine Signalleitung 29 bzw. 30. Die Signalleitungen 29 bzw. 30 sind mit ihren Eingängen 33 bzw. 34 über eine zweite Anpaßschaltungen 31 bzw. 32 an die Ausgänge 19 bzw. 20 der Hochfrequenz-Vorverstärker 11 bzw. 12 angeschlossen. Durch die zweiten Anpaßschaltungen 31 bzw. 32 erfolgt eine Wellenwiderstandstransformation von den Hochfrequenz-Vorverstärkern 11 bzw. 12 auf die Signalleitungen 29 bzw. 30. An Ausgängen 35 bzw. 36 sind die Signalleitungen 29 bzw. 30 über eine Reihenschaltung aus je einem Gleichstromtrennelement 37 bzw. 38 und einer dritten Anpaßschaltung 39 bzw. 40 mit den Ausgängen 21 bzw. 22 der zweiten Koppelglieder 13 bzw. 14 verbunden. An den Ausgängen 35 bzw. 36 der Signalleitungen 29 bzw. 30 sind zweite Gleichstromkoppelanordnungen 41 bzw. 42, an den Verbindungspunkten 43 bzw. 44 zwischen den Gleichstromtrennelementen 37 bzw. 38 und den dritten Anpaßschaltungen 39 bzw. 40 sind dritte Gleichstromkoppelanordnungen 45 bzw. 46 angeschlossen.

Bei der gezeigten Anordnung stellen die zweiten Anpaßschaltungen 31, 32 gleichstrommäßig Kurzschlüsse dar, so daß über die zweiten Gleichstromkoppelanordnungen 41, 42 unmittelbar eine Gleichstromspeisung an die Hochfrequenz-Vorverstärker 11 bzw. 12 geleitet werden kann. Die Transistoren der Hochfrequenz-Vorverstärker 11 bzw. 12 sind mit ihren Source-Anschlüssen an Masse gelegt, die Gate-Anschlüsse bilden die Eingänge (Bezugszeichen 17 bzw. 18) und die Drain-Anschlüsse die Ausgänge 19 bzw. 20. Über die ersten und die zweiten Gleichstromkoppelanordnungen 27, 28 bzw. 41, 42 werden konstante Vorspannungen eingespeist, so daß die Hochfrequenz-Vorverstärker 11, 12 stets mit einem vorzugsweisen festen Arbeitspunkt betrieben werden. Sie weisen daher feste Eingangs- und Ausgangswiderstände auf, an die die ersten und die zweiten Anpaßschaltungen 25, 26, 31, 32 mit fester Dimensionierung eine gute, breitbandige Wellenwiderstandsanpassung gewährleisten.

Die schaltbaren Hochfrequenz-Verstärkeranordnungen 15, 16 sind mit ihren Ausgängen 47, 48 über vierte Anpaßschaltungen 49 bzw. 50 mit Eingängen 51, 52 von ausgangsseitigen Signalleitungen 53, 54 der Signalverarbeitungszweig 7 bzw. 8 gekoppelt. Durch die vierten Anpaßschaltungen 49 bzw. 50 erfolgt eine Wellenwiderstandsanpassung zwischen den Ausgangswiderständen der schaltbaren Hochfrequenz-Verstärkeranordnungen 15 bzw. 16 und den ausgangsseitigen Signalleitungen 53, 54. Dabei kann diese Anpassung bevorzugt derart dimensioniert sein, daß sie für den durchgeschalteten Zustand der Hochfrequenz-Verstärkeranordnung 15 bzw. 16 optimal ist. Mit einer entsprechenden Wellenwiderstandsanpassung zwischen den zweiten Koppelgliedern 13 bzw. 14 und den schaltbaren Hochfrequenz-Verstärkeranordnungen 15 bzw. 16 über die dritten Anpaßschaltungen 39 bzw. 40, die zwischen den Verbindungspunkten 43 bzw. 44 und den Ausgängen 21 bzw. 22 der zweiten Koppelglieder 13 bzw. 14 und daher den mit diesen verbundenen Eingängen der schaltbaren Hochfrequenz-Verstärkeranordnungen 15 bzw. 16 angeordnet sind, ergibt sich im durchgeschalteten Zustand der schaltbaren Hochfrequenz-Verstärkeranordnungen 15 bzw. 16 eine optimale, d.h. verlust- und reflexionsarme Signalweiterleitung.

Die ausgangsseitigen Signalleitungen 53, 54 sind mit Ausgängen 55, 56 an Eingänge einer Überlagerungsstufe 57 angeschlossen. In der Überlagerungsstufe 57, die im einfachsten Fall durch einen Leitungsknoten gebildet ist, werden die Hochfrequenzsignale von den Signalverarbeitungszweigen 7 und 8 auf eine gemeinsame Leitung zusammengeführt, die am Ausgang 58 der Überlagerungsstufe 57 angeschlossen sein kann, in der Figur jedoch der Einfachheit halber nicht dargestellt ist. Mit den Eingängen 51 bzw. 52 der ausgangsseitigen Signalleitungen 53 bzw. 54 können außerdem weitere Gleichstromkoppelanordnungen für die schaltbaren Hochfrequenz-Verstärkeranordnungen 15 bzw. 16 verbunden sein. Im dargestellten Ausführungsbeispiel ist in vereinfachter Weise nur eine einzige, vierte Gleichstromkoppelanordnung 59 mit dem Eingang 51 der ausgangsseitigen Signalleitung 53 im ersten Signalverarbeitungszweig 7 verbunden. Die schaltbaren Hochfrequenz-Verstärkeranordnungen 15, 16 sind bevorzugt mit wenigstens nahezu identischen Transistoren, vorteilhaft "HEMT"-Transistoren, ausgeführt, die entsprechend den Transistoren in den Hochfrequenz-Vorverstärkern 11 bzw. 12 angeordnet sind: Ihr Gate-Anschluß ist mit den Ausgängen 21 bzw. 22 der zweiten Koppelglieder 13 bzw. 14, ihr Source-Anschluß ist mit Masse und ihr Drain-Anschluß ist mit dem Ausgang 47 bzw. 48 der schaltbaren Hochfrequenz-Verstärkeranordnung 15 bzw. 16 verbunden. Die vierten Anpaßschaltungen 49, 50 und die Überlagerungsstufe 57 sind gleichstromdurchlässig, so daß über die vierte Gleichstromkoppelanordnung 59, die für die Hochfrequenzsignale vorzugsweise einen Leerlauf bildet, ggf. in gemeinsamer Dimensionierung mit der vierten Anpaßschaltung 49 des ersten Signalverarbeitungszweiges 7, für die Drain-Anschlüsse der Transistoren in den schaltbaren Hochfrequenz-Verstärkeranordnungen 15 und 16 eine gemeinsame Gleichvorspannung eingespeist werden kann. Das wahlweise Durchschalten bzw. Sperren der schaltbaren Hochfrequenz-Verstärkeranordnungen 15 bzw. 16 erfolgt dann bevorzugt über die mittels der dritten Gleichstromkoppelanordnungen 45 bzw. 46 zugeführten Gleichvorspannungen für die Gate-Anschlüsse der Transistoren in den schaltbaren Hochfrequenz-Verstärkeranordnungen 15 bzw. 16, wohingegen die Gleichvorspannung über die vierte Gleichstromkoppelanordnung 59 konstant gehalten werden kann.

Die Leitungslängen der ausgangsseitigen Signalleitungen 53 bzw. 54 sind ggf. in gemeinsamer Dimensionierung mit den vierten Anpaßschaltungen 49 bzw. 50 derart dimensioniert, daß an den Ausgängen 55 bzw. 56 bei gesperrtem Zustand der zugehörigen, schaltbaren Hochfrequenz-Verstärkeranordnung 15 bzw. 16 ein Leerlauf erscheint. Der gesperrte Signalverarbeitungszweig bildet dann für den durchgeschalteten, wirksamen Signalverarbeitungszweig keine Störung.

Anhand des in der Figur dargestellten Ausführungsbeispiels ist auch deutlich erkennbar, daß durch die als Entkopplung wirkenden Hochfrequenz-Vorverstärker 11 bzw. 12 unterschiedliche Eingangswiderstände der schaltbaren Hochfrequenz-Verstärkeranordnungen 15 bzw. 16 in ihren durchgeschalteten bzw. gesperrten Zuständen keine Rückwirkungen auf die Eingangswiderstände an den Anschlüssen 5 bzw. 6 der Einkoppelvorrichtungen 2 bzw. 3 haben. Dadurch ist die hier geforderte Anpassung unabhängig vom Schaltzustand der schaltbaren Hochfrequenz-Verstärkeranordnungen 15, 16 gewährleistet.

Das gezeigte Ausführungsbeispiel eignet sich bevorzugt zum getrennten Empfangen kreuzpolarisierter Hochfrequenzsignale und gewährleistet eine sehr gute Trennung der orthogonal polarisierten Wellen. Dabei ist der Empfang sehr breitbandiger Signale möglich, ohne daß die Dimensionierung einzelner Leitungslängen, insbesondere der Längen der Signalleitungen 23 und 24, kritisch ist. Es treten nur geringe Koppelverluste auf, und das Rauschen kann niedrig gehalten werden, so daß insgesamt eine sehr störungsarme Übertragung ermöglicht wird.

## Patentansprüche

1. Schaltungsanordnung zum Verarbeiten wahlweise eines ersten oder eines zweiten Hochfrequenzsignals mit
- einer ersten Einkoppelvorrichtung (2) zum Einkoppeln des ersten Hochfrequenzsignals von einer gemeinsamen Wellenleiteranordnung (1) auf einen ersten Signalverarbeitungszweig (7),
- einer zweiten Einkoppelvorrichtung (3) zum Einkoppeln des zweiten Hochfrequenzsignals von der gemeinsamen Wellenleiteranordnung (1) auf einen zweiten Signalverarbeitungszweig (8),
- je einer schaltbaren Hochfrequenz-Verstärkeranordnung (15; 16) in jedem Signalverarbeitungszweig (7, 8) zum wahlweisen Durchschalten und Verstärken bzw. Sperren des zugehörigen, eingekoppelten Hochfrequenzsignals,
**gekennzeichnet durch**
- je eine Übertragungsanordnung (9, 11, 13; 10, 12, 14) in jedem Signalverarbeitungszweig (7, 8) zum Übertragen des zugehörigen Hochfxequenzsignals von der ersten (2) bzw. zweiten (3) Einkoppelvorrichtung an die zugehörige, schaltbare Hochfrequenz-Verstärkeranordnung 15; 16),
- wobei jede der Übertragungsanordnungen (9, 11, 13; 10, 12, 14) einen Hochfrequenz-Vorverstärker (11; 12) umfaßt, der über ein erstes Koppelglied (9; 10) mit der zugehörigen Einkoppelvorrichtung (2; 3) und über ein zweites Koppelglied (13; 14) mit der zugehörigen schaltbaren Hochfrequenz-Verstärkeranordnung (15; 16) verbunden ist, wobei **durch** die ersten Koppelglieder (9; 10) eine Wellenwiderstandsanpassung zwischen den Einkoppelvorrichtungen (2; 3) und den zugehörigen Hochfrequenz-Vorverstärkern (11; 12) und **durch** die zweiten Koppelglieder (13; 14) eine Wellenwiderstandsanpassung zwischen den Hochfrequenz-Vorverstärkern (11; 12) und den zugehörigen, schaltbaren Hochfrequenz-Verstärkeranordnungen (15; 16) erfolgt und die letztgenannte Wellenwiderstandsanpassung sowohl für den durchgeschalteten als auch den gesperrten Zustand der zugehörigen Hochfrequenzverstärkeranordnung (15; 16) vorgenommen ist.

2. Schaltungsanordnung nach Anspruch 1, **dadurch gekennzeichnet,**
**daß** die Wellenleiteranordnung (1) mit einem Hohlraum (4) ausgeführt ist und daß die Einkoppelvorrichtungen (2; 3) je eine in diesen Hohlraum (4) ragende Sonde umfassen, wobei die Sonden auf die Wellenlänge der im Hohlraum (4) der Wellenleiteranordnung (1) geführten Hochfrequenzsignale derart abgestimmt sind, daß sie die Energie dieser Hochfrequenzsignale aus der Wellenleiteranordnung (1) möglichst gut aufnehmen.

3. Schaltungsanordnung nach Anspruch 1 oder 2, **dadurch gekennzeichnet,**
**daß** die ersten Koppelglieder (9; 10) je eine Signalleitung (23; 24) umfassen, über die die Hochfrequenzsignale von der zugehörigen Einkoppelvorrichtung (2; 3) zum zugehörigen Hochfrequenz-Vorverstärker (11; 12) geleitet wird, und daß Länge und Wellenwiderstand dieser Signalleitung (23; 24) auf eine wenigstens nahezu reflexionsfreie Signalübertragung abgestimmt sind.

4. Schaltungsanordnung nach Anspruch 1, 2 oder 3, **dadurch gekennzeichnet,**
**daß** die Hochfrequenz-Vorverstärker (11; 12) und die Hochfrequenz-Verstärkeranordnungen (15; 16) mit Transistoren mit hoher Ladungsträgerbeweglichkeit ausgebildet sind.

5. Schaltungsanordnung nach einem der vorhergehenden Ansprüche, **dadurch gekennzeichnet,**
**daß** die zweiten Koppelglieder (13; 14) je ein Gleichstromtrennelement (37; 38) aufweisen zum gleichstrommäßigen Trennen der Hochfrequenz-Vorverstärker (11; 12) von den zugehörigen Hochfrequenz-Verstärkeranordnungen (15; 16).

## Claims

1. Circuit arrangement for processing optionally a first or a second radio-frequency signal having
- a first coupling-in device (2) for coupling in the first radio-frequency signal from a common waveguide arrangement (1) onto a first signal processing branch (7),
- a second coupling-in device (3) for coupling the second radio-frequency signal from the common waveguide arrangement (1) onto a second signal processing branch (8),
- a respective switchable radio-frequency amplifier arrangement (15; 16) in each signal processing branch (7, 8) for optionally switching through and amplifying or blocking the associated, coupled-in radio-frequency signal,
**characterized by**
- a respective transfer arrangement (9, 11, 13; 10, 12, 14) in each signal processing branch (7, 8) for transferring the associated radio-frequency signal from the first (2) or, respectively second (3) coupling-in device to the associated switchable radio-frequency amplifier arrangement (15; 16),
- each of the transfer arrangements (9, 11, 13; 10, 12, 14) comprising a radio-frequency preamplifier (11; 12), which is connected to the associated coupling-in device (2; 3) via a first coupling element (9; 10) and to the associated switchable radio-frequency amplifier arrangement (15; 16) via a second coupling element (13; 14), the first coupling elements (9; 10) effecting a characteristic impedance matching between the coupling-in devices (2; 3) and the associated radio-frequency preamplifiers (11; 12) and the second coupling elements (13; 14) effecting a characteristic impedance matching between the radio-frequency preamplifiers (11; 12) and the associated switchable radio-frequency amplifier arrangements (15; 16) and the last-mentioned characteristic impedance matching being performed both for the switched-through and for the blocked state of the associated radio-frequency amplifier arrangement (15; 16).

2. Circuit arrangement according to Claim 1,
**characterized**
**in that** the waveguide arrangement (1) is embodied with a cavity (4), and in that the coupling-in devices (2; 3) respectively comprise a probe projecting into the said cavity (4), the probes being coordinated with the wavelength of the radio-frequency signals guided in the cavity (4) of the waveguide arrangement (1) in such a way that they take up the energy of the said radio-frequency signals from the waveguide arrangement (1) as well as possible.

3. Circuit arrangement according to Claim 1 or 2,
**characterized**
**in that** the first coupling elements (9; 10) respectively comprise a signal line (23; 24), via which the radio-frequency signals are conducted from the associated coupling-in device (2; 3) to the associated radio-frequency preamplifier (11; 12), and in that the length and characteristic impedance of the said signal line (23; 24) are coordinated with an at least virtually reflection-free signal transfer.

4. Circuit arrangement according to Claim 1, 2 or 3,
**characterized**
**in that** the radio-frequency preamplifiers (11; 12) and the radio-frequency amplifier arrangements (15; 16) are designed with transistors with high charge carrier mobility.

5. Circuit arrangement according to one of the preceding claims,
**characterized**
**in that** the second coupling elements (13; 14) respectively have a DC isolating element (37; 38) for DC isolation of the radio-frequency preamplifiers (11; 12) from the associated radio-frequency amplifier arrangements (15; 16).

## Revendications

1. Circuit de traitement au choix d'un premier ou d'un second signal à haute fréquence, avec
- un premier dispositif de couplage (2) pour coupler le premier signal à haute fréquence provenant d'un dispositif guide d'ondes commun (1) à une première branche de traitement de signal (7),
- un second dispositif de couplage (3) pour coupler le second signal à haute fréquence provenant du dispositif guide d'ondes commun (1) à une seconde branche de traitement de signal (8),
- un dispositif respectif d'amplificateur à haute fréquence (15; 16) à connecter dans chaque branche de traitement de signal (7, 8) pour la connexion et l'amplification, respectivement l'arrêt, au choix du signal à haute fréquence couplé correspondant,
**caractérisé par**
- un dispositif respectif de transfert (9, 11, 13; 10, 12, 14) dans chaque branche de traitement de signal (7, 8) pour transférer le signal à haute fréquence associé du premier (2), respectivement du second (3) dispositif de couplage au dispositif d'amplificateur à haute fréquence associé à connecter (15; 16),
- dans lequel chacun des dispositifs de transfert (9, 11, 13; 10, 12, 14) comprend un préamplificateur à haute fréquence (11; 12), qui est raccordé par un premier organe de couplage (9; 10) au dispositif de couplage associé (2; 3) et par un second organe de couplage (13; 14) au dispositif d'amplificateur à haute fréquence associé à connecter (15; 16), dans lequel il se produit par les premiers organes de couplage (9; 10) une adaptation de l'impédance caractéristique entre les dispositifs de couplage (2; 3) et les préamplificateurs à haute fréquence associés (11; 12) et par les seconds organes de couplage (13; 14) une adaptation de l'impédance caractéristique entre les préamplificateurs à haute fréquence (11; 12) et les dispositifs d'amplificateurs à haute fréquence associés à connecter (15; 16), et cette dernière adaptation de l'impédance caractéristique est effectuée aussi bien pour l'état connecté que pour l'état arrêté du dispositif d'amplificateur à haute fréquence associé (15; 16).

2. Circuit selon la revendication 1, **caractérisé en ce que** le dispositif guide d'ondes (1) est réalisé avec un espace creux (4) et **en ce que** les dispositifs de couplage (2; 3) comprennent chacun une sonde pénétrant dans cet espace creux (4), dans lequel les sondes sont accordées sur la longueur d'onde des signaux à haute fréquence circulant dans l'espace creux (4) du dispositif guide d'ondes (1), de telle manière qu'elles captent aussi bien que possible l'énergie de ces signaux à haute fréquence dans le dispositif guide d'ondes (1).

3. Circuit selon la revendication 1 ou 2, **caractérisé en ce que** les premiers organes de couplage (9; 10) comprennent chacun une ligne de signaux (23; 24), par laquelle les signaux à haute fréquence sont conduits du dispositif de couplage associé (2; 3) au préamplificateur à haute fréquence associé (11; 12), et **en ce que** la longueur et l'impédance caractéristique de cette ligne de signaux (23; 24) sont accordées sur un transfert de signaux au moins presque sans réflexion.

4. Circuit selon la revendication 1, 2 ou 3, **caractérisé en ce que** les préamplificateurs à haute fréquence (11; 12) et les dispositifs d'amplificateurs à haute fréquence (15; 16) sont formés avec des transistors à haute mobilité des porteurs de charge.

5. Circuit selon l'une quelconque des revendications précédentes, **caractérisé en ce que** les seconds organes de couplage (13; 14) présentent chacun un élément de blocage du courant continu (37; 38) pour interrompre la liaison de courant continu entre les préamplificateurs à haute fréquence (11; 12) et les dispositifs d'amplificateurs à haute fréquence associés (15; 16).
